# EUROPEAN PATENT SPECIFICATION

(11) **EP 0 448 248 B1**
(45) Date of publication and mention of the grant of the patent: **26.06.2002**
(21) Application number: 91301855.2
(22) Date of filing: 07.03.1991
(51) Int. Cl.: C09D 179/08, C08J 3/09, C08L 79/08, C08G 73/10

(54) **Process for making thick multilayers of polyimide**
Verfahren zur Herstellung von dicken Multilayer aus Polyimid
Procédé de fabrication de multicouches épais de polyimide

(30) Priority: 09.03.1990 US 491437; 13.11.1990 US 613153
(43) Date of publication of application: 25.09.1991
(73) Proprietor: The Texas A & M University System, College Station, TX 77840 (US)
(72) Inventor: Burgess, Marvin Jay, Lisle, IL 60532 (US); Fjare, Douglas Eric, Naperville, Illinois 60540 (US); Neuhaus, Herbert John, Naperville, Illinois 60540 (US); Roginski, Robert Theodore, Lisle, Illinois 60532 (US); Wargowski, David Allen, Naperville, Illinois 60565 (US)
(74) Representative: Ritter, Stephen David

(56) References cited:
- EP-A- 0 328 027
- EP-A- 0 330 456
- EP-A- 0 335 337
- WO-A-89/10946
- FR-A- 2 476 667
- US-A- 4 255 471
- US-A- 4 382 126
- US-A- 4 874 834
- US-A- 4 876 329
- Polymers for High Technology, Bowden and Turner (eds.), ACS Symposium Series, 1987; Chapter 37; pp. 437-43;"Soluble Aromatic Polyimides for Film and Coating Applications; A.K. St. Clair et al.

## Description

### Field Of The Invention

This invention relates to a method to produce layers of polyimide in electronic applications and more particularly relates to a method to make thick (e.g., more than 5 µm), fluorinated polyimide layers on a substrate by a selection of solvent carrier.

### Background Of The Invention

Polyimides, particularly aromatic polyimides, have found extensive use in microelectronic devices due to their high thermal stability, low dielectric constant and high electrical resistivity. Aromatic polyimides typically are formed by dissolving an aromatic diamine in a compatible solvent and then adding a dianhydride which reacts with the diamine to make a solution of polyamic acid. The resulting solution of polyamic acid can be coated onto a substrate, the solvent evaporated, and the polyamic acid imidized. Conventional solvents for forming the polyamic acid and subsequent imidization include polar aprotic solvents such as N-methylpyrrolidinone (NMP).

Polyimide-based polymers are disclosed in FR-A-2,476,667, US-A-4,382,126, US-A-4,255,471, US-A-4,874,834, US-A-4,876,329, EP-A-0,328,027, EP-A-0,335,337, EP-A-0,330,456 and WO 89/10946 and uses thereof are described inter alia as coating materials and for forming shaped articles.

Further, EP-A-0,335,337 describes flexible printed circuit base materials comprising at least one layer of a polyimide resin having low thermal expansion and at least one layer of polyimide resin having high thermal expansion.

A multilayer interconnect structure, such as a microelectronic multichip module, consists of alternate layers of a conducting material and a material having a low dielectric constant (an insulating material). In particular, polyimides containing fluorine provide a material with a low dielectric constant and low moisture absorption while maintaining desirable features of polyimides such as excellent thermal stability, high glass transition temperature (Tg), and good solvent resistance.

Typically, thick polyimide layers are formed from a number of thin coats of polyamic acid. Each thin coat is imidized before the next coat is applied. However, fluorinated polyimides are degraded by many conventional polar aprotic solvents, such as NMP. It has been observed that these conventional polar aprotic solvents interact with the polyimide and result in cracking of thick layers of the polyimide.

To eliminate the cracking problem a number of approaches can be taken. One approach would be to select polyimides such that the polyimide has a linear coefficient of thermal expansion that matches that of the substrate. This would minimize the stress present in the polyimide film after curing and can make the polymer less susceptible to cracking or crazing. However, few polyimide structures have the very low linear coefficient of expansion required to match typical substrates. Further, these polyimides may not exhibit the low dielectric constant and low moisture absorption that is desirable in electronic applications.

Another approach is to select an alternative solvent system that is less aggressive toward the polyimide. The alternative solvent must not be so volatile that it will evaporate before the polymer solution can be applied to the substrate. It has been found that solvents having a boiling point greater than 150°C will spread to coat the substrate without undue evaporation. Further, the polymer must be sufficiently soluble in the solvent or solvent system for multilayer processing. In other words, the solvent must be able to keep the polymer solvated during the coating of the substrate. The polymer solution should have relatively stable solution viscosity. Finally, the solvent must not attack the underlying polyimide during the multilayer processing steps.

According to the present invention there is provided a method of forming a multilayer polyimide coated substrate which comprises providing successive layers of fluorinated polyimide on the substrate, each layer being at least 5µm thick characterised by the steps of
(a) forming a first polyimide layer comprising a fluorinated polyimide which is susceptible to degradation by conventional aprotic polar solvents by applying a first layer of polyamic acid to the substrate,
(b) imidizing the first layer of polyamic acid to form said first polyimide layer, and
(c) providing a second polyimide layer comprising a fluorinated polyimide over the first polyimide layer by
   (i) applying a solution in a solvent, of a polyamic acid or a polyimide, and
   (ii) if necessary, imidizing polyamic acid applied in step (i),
and wherein said solvent consists of one or more compounds of the formula (I) 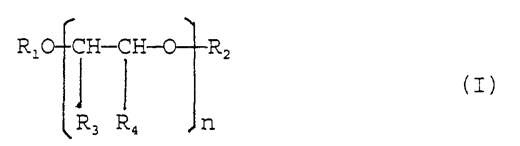 and optionally a small amount of polar aprotic solvent, said amount not resulting in cracking of the underlying layer, wherein
R₁ and R₂ are independently hydrogen, a C₁ to C₆ alkyl moiety, or 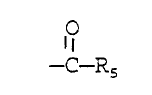 wherein R₅ is a C₁ to C₆ alkyl moiety;
R₃ and R₄ are independently hydrogen or a C₁ to C₆ alkyl moiety; and
n is from 1 to 4.

The invention further provides a method of preventing cracking in an underlying polyimide layer on a substrate wherein said underlying layer comprises a fluorinated polyimide which is susceptible to degradation by conventional aprotic polar solvents when additional layers of fluorinated polyamic acid are applied to the underlying polyimide layer which comprises:
(a) forming a first polyimide layer comprising a fluorinated polyimide which is susceptible to degradation by conventional aprotic polar solvents by applying a first layer of polyamic acid to the substrate;
(b) imidizing the first layer of polyamic acid to provide said first polyimide layer; and
(c) applying a layer of fluorinated polyamic acid over the first layer of polyimide wherein the polyamic acid is in a solvent of the formula 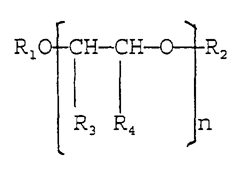 wherein
   R₁ and R₂ are independently hydrogen, a C₁ to C₆ alkyl moiety, or 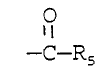 wherein R₅ is a C₁ to C₆ alkyl moiety;
   R₃ and R₄ are independently hydrogen or a C₁ to C₆ alkyl moiety; and
   n is from 1 to 4, and
(d) imidizing the polyamic acid.

Also provided in accordance with the invention is a method of forming multiple layers of fluorine-containing polyimide on a substrate which comprises:
(a) applying a first layer of fluorine-containing polyamic acid to the substrate;
(b) imidizing the first layer of polyamic acid to provide a first polyimide layer;
(c) applying a layer of fluorinated polyamic acid over the first layer of polyimide wherein the polyamic acid is in a solvent of the formula 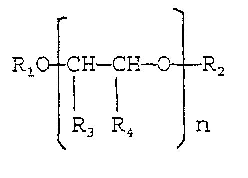 wherein
   R₁ and R₂ are independently hydrogen, a C₁ to C₆ alkyl moiety, or 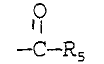 wherein R₅ is a C₁ to C₆ alkyl moiety;
   R₃ and R₄ are independently hydrogen or a C₁ to C₆ alkyl moiety; and
   n is from 1 to 4 and
(d) imidizing the polyamic acid.

Prefered embodiments of the present invention are set out in the dependent Claims 2 to 9, 11, and 13 to 15.

The method of the present invention can be applied to the formation of thick layers in many electronic applications, for example passivation or electronic chip coatings, and multilayer applications such as interlayer dielectric or multichip module applications. In addition, the method of the present invention can be applied to cladding material for plastic optical waveguides and fibers, planarization coatings over patterned metal or patterned polymer, and metal lift-off stencils.

The fluorinated polyimide layer produced in step (c) can be formed by reacting a diamine and a dianhydride in a solvent of Formula I to form a fluorinated polyamic acid.

Alternatively, the polyamic acid can be prepared in another solvent, such as NMP. In this case, the solvent can be substantially removed by any means known by those skilled in the art, such as evaporation. The polyamic acid then can be redissolved in the solvent of Formula I. In other words, the practice of the invention is not restricted to only those polyamic acids that are prepared in the solvent of Formula I.

Where the polyimide is soluble in the solvent of Formula I, the polyamic acid can be thermally or chemically imidized and the polyimide can be coated onto the substrate. If the polyamic acid is thermally imidized in the solvent of Formula I, the polyamic acid solution can be used directly. However, if the polyamic acid is chemically imidized the byproducts of the chemical imidization are removed, typically by precipitation of the polyimide from solution, and the polymer is redissolved in the solvent of Formula I.

The solvents of Formula I typically have a boiling point above 150°C. Many of the solvents of Formula I will solubilize the resulting polyamic acid or polyimide to form polymer solutions having relatively stable solution viscosity. The polymer solutions will not attack the underlying polyimide during the multilayer processing steps. The solvents of Formula I are particularly effective for making thick multilayers of fluorinated polymer, for example, the reaction product of a dianhydride, such as 2,2-bis(3,4-dicarboxyphenyl)hexafluoropropane dianhydride (6FDA), and at least one diamine.

### Brief Description Of The Invention

In this invention a layer of, a fluorinated polyimide, can be formed by coating a substrate with a precursor polyamic acid and curing the precursor polyamic acid to form the fluorinated polyimide. The polyamic acid is generally cured at elevated temperatures, typically from 100°C to 500°C, more typically from 250°C to 400°C, to form a cured fluorinated polyimide layer.

Alternatively, the fluorinated polyamic acid can be imidized, coated on the substrate, and cured. If the fluorinated polyamic acid is thermally imidized e.g. in the solvent of Formula I, the polyamic acid solution can be used directly. However, if the polyamic acid is chemically imidized the byproducts of the chemical imidization are removed, typically by precipitation of the polyimide from solution, and the polymer is redissolved e.g. in the solvent of Formula I. The polyimide layer is generally subjected to a final cure to assure completion of the imidization and substantially remove any residual solvent. The final cure is generally at elevated temperatures, typically from 100°C to 500°C, more typically from 250°C to 400°C.

Suitable solvents, according to Formula I, include lower alkyl ether alcohols. Examples are lower alkyl (C₂-C₆) ether alcohols, for example, 2-(2-ethoxyethoxy)ethanol, 2-(2-methoxyethoxy)ethanol and 2-(2-butoxyethoxy)ethanol.

Suitable solvents, according to Formula I, also include alkyl ethers, such as for example, ethylene glycol dimethyl ether (glyme), ethylene glycol diethyl ether, 2-methoxyethyl ether (diglyme), 2-ethoxyethyl ether, triethylene glycol dimethyl ether (triglyme), tetraethylene glycol dimethyl ether (tetraglyme), propylene glycol dimethyl ether and dipropylene glycol dimethyl ether. Suitable solvents also include mixed ethers, such as ethylene glycol ethyl methyl ether and tetraethylene glycol ethyl methyl ether.

Additional suitable solvents according to Formula I include those solvents where R₁ and R₂ are acetate, propionate, or butanoate. For example, propylene glycol methyl ether acetate, 2-ethoxyethyl acetate and 2-(2-ethoxyethoxy)ethyl acetate.

Further, a cosolvent system can be prepared where two or more solvents of Formula I are present. For example, an 2-(ethoxyethoxy)ethanol/diglyme cosolvent system (see Example 5).

The solvent systems of the present invention can also contain a small amount of a polar aprotic solvent, such as NMP (for example, see Example 4).

Generally, polymers included in the present invention include polyimides and polyamic acids. The polyimides have recurring units of Formula II 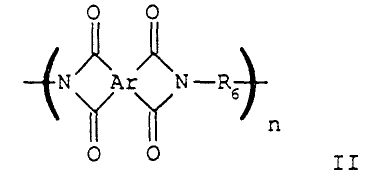 wherein Ar is at least one tetravalent aromatic nucleus; R₆ is a divalent hydrocarbon moiety which can be an aromatic or an aliphatic moiety or an amine-terminated poly(dialkylsiloxane) moiety; and n is an integer representing the number of repeating units to provide a molecular weight usually of 1,000 to 100,000 daltons. Ar and R₆ can be substituted or unsubstituted, for example, with an alkyl group of 1 to 4 carbon atoms or halogen.

The polyamic acids include recurring units of Formula III 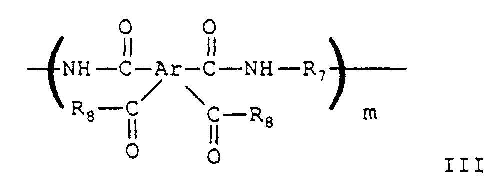 wherein Ar is defined above; R₇ is a divalent hydrocarbon moiety which can be an aromatic or aliphatic moiety or an amine-terminated poly(dialkylsiloxane) moiety; R₈ is independently selected from halogen, -OH, and -OR₉; R₉ is an alkyl group of 1 to 4 carbon atoms or halogen; and m is an integer representing the number of repeating units to provide a molecular weight usually of 1,000 to 100,000 daltons. R₇, R₈ and R₉ can be substituted or unsubstituted, for example, with an alkyl group of 1 to 4 carbon atoms or halogen.

In greater detail, the aromatic moieties, Ar in Formulas II and III, are individually characterized by a single aromatic ring or by two or more such rings which are fused together or are joined by one or more stable linkages, such as a covalent carbon-carbon bond, oxy, sulfonyl, carbonyl and alkylene. The aromatic moiety, Ar, can include divalent moieties of e.g. benzene, naphthalene, phenanthrene and anthracene. Further, the aromatic rings can be unsubstituted or substituted, for example, with one or more lower alkyl groups or halogen.

Specific examples of suitable Ar moieties include 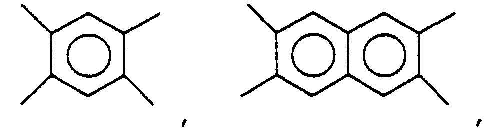 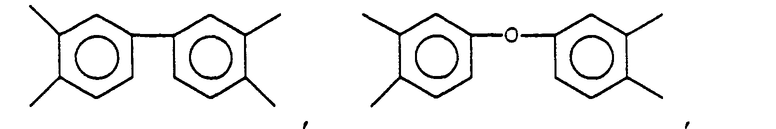 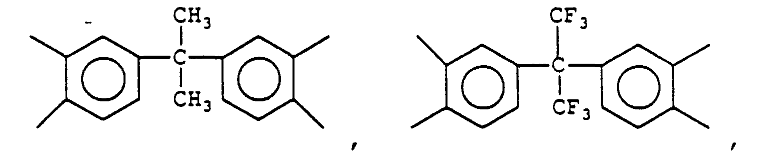 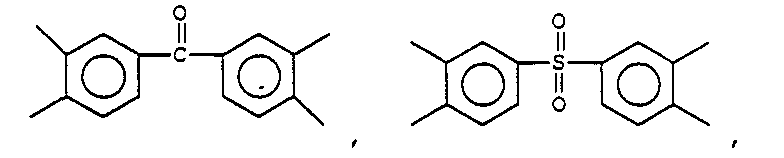 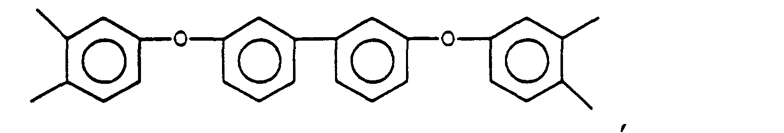 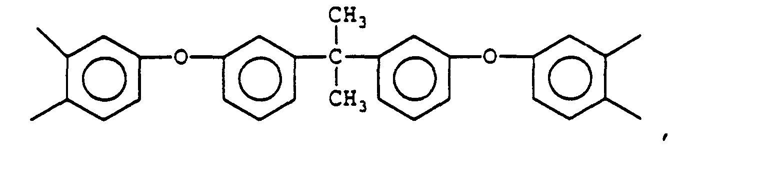 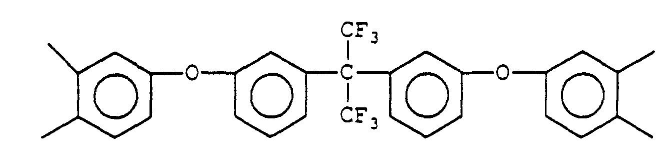 and

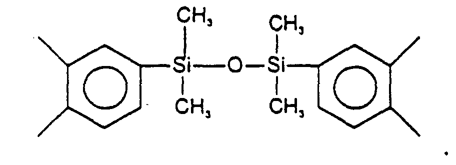

The divalent hydrocarbon moieties, R₆ and R₇ in Formulas II and III, are individually selected from an aliphatic or an aromatic moiety. The aliphatic moiety is characterized by a straight or branched-chain hydrocarbon, such as, for example, methylene, ethylene, propylene, tetramethylene, hexamethylene, octamethylene, nonamethylene, decamethylene and dodecamethylene, which can be unsubstituted or substituted with one or more halide such as fluorine, siloxane such as aminopropyl-terminated polydimethylsiloxane, or lower alkyl groups such as for example, 2,2,4-trimethylhexamethylene and 2,2-dimethylpropylene. The aromatic moiety is characterized by a single aromatic ring or by two or more such rings which are fused together or are joined by one or more stable linkages, such as a covalent carbon-carbon bond, oxy, sulfonyl, carbonyl and alkylene. The aromatic moiety can include tetravalent moieties of e.g., benzene, naphthalene, phenanthrene and anthracene. Further, the aromatic rings can be unsubstituted or substituted, for example, with one or more halide or lower alkyl groups.
The polyamic acid precursors typically are made from aromatic dianhydrides, including their ester and acid forms, and at least one aromatic diamine. Suitable diamines include 2,2-bis(4-(p-aminophenoxy)phenyl)hexafluoropropane (BDAF), 3,5-diamino-t-butylbenzene (DATB), 3,5-diaminobenzotrifluoride (DABF), 4,4'-bis(p-aminophenoxy)biphenyl (APBP), 2,2-bis(4-aminophenyl)propane (BAA), 2,2-bis(4-aminophenyl)hexafluoropropane (BAAF), 4,4'-bis(4-amino-2-trifluoromethylphenoxy)biphenyl (FAPB), m-phenylenediamine (MPDA), p-phenylenediamine (PPDA), 4,4'-diaminodiphenylether (OBA), 2,2-bis[4-(p-aminophenoxy)phenyl]propane (BAPP), 4,4'-[1,4-phenylene-bis(1-methylethylidene)]bisaniline (BAP) and 3',5-diamino-1,3,3,6'-tetramethyl-1-(4'-tolyl)indan (DATI).

Suitable dianhydrides include the dianhydrides of benzene, naphthalene, biphenyl (BPDA), diphenylether, benzophenone (BTDA), pyromellitic dianhydride (PMDA), bis-(3,4-dicarboxyphenyl)ether dianhydride (OPAN), bis(3,4-carboxyphenyl)sulfone dianhydride (SPAN), 2,2-bis(3,4-dicarboxyphenyl)propane dianhydride (IPAN), 2,2-bis(3,4-dicarboxyphenyl)hexafluoropropane dianhydride (6FDA) and 1,3-bis(3,4-dicarboxyphenyl)tetramethyldisiloxane dianhydride (PADS).

The polyamic acid is typically prepared as the condensation product of one or more diamines and one or more dianhydrides to form homopolymers or copolymers. Copolymers can contain any amount of additional anhydrides or diamines. The total diamine and total dianhydride components are typically present in a ratio of approximately 1:1. However, by using an excess of diamine or dianhydride in the reaction mixture (typically ranging from 0.9:1 to 1.1:1), the chain length of the product can be adjusted. Further, the chain length can be restricted by adding a predetermined quantity of a monoamine or a monocarboxylic acid anhydride to the reaction mixture.

In the practice of the present invention, the polyamic acid of step (c) can be prepared, and the polyimide layer can be formed, in the solvent of Formula I. Alternatively, the polyamic acid can be prepared in a conventional solvent, for example NMP. The conventional solvent can be substantially removed, for example by evaporation, and the polyamic acid can be redissolved in the solvent of Formula I.

In greater detail, a solution of polyamic acid is prepared by reacting a diamine such as APBP stoichiometrically with a dianhydride such as 6FDA in a suitable solvent, which can be a solvent according to Formula I or a conventional solvent, such as NMP. The reaction generally takes place at from minus 10°C to 100°C. If a conventional solvent such as NMP is used, the conventional solvent is substantially removed by any means known to those skilled in the art, such as evaporation. Thereafter, the polyamic acid is redissolved in a solvent of Formula I.

Alternatively, the polyamic acid can be imidized, used in step (c), and cured. If the polyamic acid is thermally imidized in the solvent of Formula I, the polyamic acid solution can be used directly. However, if the polyamic acid is chemically imidized the byproducts of the chemical imidization are removed, typically by precipitation of the polyimide from solution, and the polymer is redissolved in the solvent of Formula I.

Chemical imidization is generally accomplished using dehydrating agents, such as, for example, acetic anhydride or trifluoro-acetic anhydride. Other examples of suitable dehydrating agents can be found in Bessonov, M.I. et al., Polyimides - Thermally Stable Polymers, Consultants Bureau, New York, 76-82 (1987). A particularly suitable chemical imidization composition is the dehydrating agent, acetic anhydride, used in the presence of a catalyst such as pyridine or triethylamine. Also preferred are 1,3-dicyclohexylcarbodiimide (DCC), thionyl chloride, phosphorous trichloride and trifluoroacetic anhydride.

The polyimide layer formed in step (c) is generally subjected to a final cure to assure completion of the imidization and substantially remove any residual solvent. The final cure is generally at elevated temperatures, typically from 100°C to 500°C, more typically from 250°C to 400°C.

The solution of polyamic acid or polyimide in a solvent of Formula I is spin-coated onto a substrate, such as a silicon wafer, and cured, typically at elevated temperatures. Curing the polymer will imidize the polymer and substantially remove the solvent. The cure temperature typically ranges from 100°C to 500°C, more typically from 250°C to 400°C. The polyimide layer is preferably more than 5 µm and more preferably is 10 to 30 µm thick. The curing cycle can be ramped by increasing the curing temperature in stages from one hour to 8 hours.

One or more fluorinated polyimide layers can be deposited on the substrate to form the thick layer. However, each layer of polymer is at least partially cured before adding the next layer of polymer. Otherwise, the solvent from the later applied polymer solution could wash away the uncured first layer of polymer.

In general, the solution of polyamic acid or polyimide is diluted before it is spread on the substrate. The degree of dilution of the solution of polyamic acid or polyimide is based on the thickness requirement of the final coating, the viscosity and solids content of the solution, and the spin curve data for the polymer. Solutions of the polyamic acid or polyimide generally range from 5 to 50 weight percent, preferably, from 10 to 40 weight percent, depending upon the molecular weight, to provide the proper viscosity for application to the substrate by spin coating.

The spin curve data can be obtained by spin-coating the polymer onto the substrate at various spin speeds, curing the polymer, measuring the resulting thickness, and plotting thickness versus spin speed. The diluted solution is generally filtered before further processing. The polymer solution can be applied either statically or dynamically. In static application, the polymer solution is dispensed to a nonrotating substrate and spread across the surface by spinning. In dynamic application, the polymer solution is dispensed to a rotating substrate. In either case, the substrate is spun at a spin speed which is determined from the spin curve for the final coating thickness required.

Alternatively, the polymer can be applied to suitable carriers, or substrates, by other conventional methods, which can include, but are not necessarily limited to, dipping, brushing, casting with a bar, roller-coating, spray-coating, dip-coating, whirler-coating, cascade-coating or curtain-coating.

Examples of suitable carriers, or substrates, are plastics, metal and metal alloys, semi-metals, semiconductors, such as Si, Ge, GaAs, glass, ceramics and other inorganic materials, for example, SiO₂ and Si₃N₄. Further, the substrate can be dried (dehydration) to remove moisture on the surface of the substrate before the application of the polymer.

If desired, an adhesion promoter can be used to secure the polymer to the substrate. Adhesion promoters are well known and are commercially available. A suitable adhesion promoter is 3-aminopropyltriethoxysilane (APES) which is available from Aldrich.

Alternatively, a minor amount of amine-terminated siloxane moiety can be incorporated into the polymer to improve the adhesion of the polymer to the substrate. In this case, less than 10 weight percent amine-terminated siloxane moiety can be added so long as the thermal properties of the polymer are not severely affected. Suitable amine-terminated siloxane moieties are typically derived from siloxane-containing diamines having from 1 to 40 disubstituted siloxyl units. Suitable siloxane diamines include bis-aminopropyl polydimethylsiloxane, bis-aminopropyl polydiethylsiloxane, bis-aminopropyl polydipropylsiloxane and diphenyl siloxanes.

The polymer coatings formed according to the method of the invention may be etched using conventional methods including dry etching and wet etching.

Dry etching can include laser drilling (laser ablation) or the use of gaseous plasmas of oxygen or oxygen/carbon fluoride containing mixtures which are exposed to a polyimide.

Polymer wet-etching processes differ depending on the state of cure (or imidization) of the polyimide. Fully or substantially fully cured polyimides can be etched using either hydrazine hydrate or ethylene diamine. Wet etching of partially cured polyamic acid films can include the use of basic solutions, for example, aqueous solutions of either tetramethylammonium hydroxide or sodium hydroxide. For example, a 6FDA/APBP polyamic acid can be etched with an aqueous solution of a nonionic base such as triethanolamine (TEA), and a substituted hydrocarbon solvent such as methanol, wherein a major portion of the solution is water and less than 1 weight percent of the total composition of the solution is an ionic base such as tetramethylammonium hydroxide (TMAH).

Typically, in a wet-etching process, the polymer is coated on the substrate and soft baked to remove solvent. The polymer-coated substrate is then coated with the positive photoresist material (for example, a commercially available, light sensitive polymer is available from Hoechst AG under the tradename AZ 1350J®), and the coated substrate is heated at an elevated temperature (from 75°C to 150°C) to remove the solvents from the photoresist material.

The photoresist material is then covered with a mask containing a pattern of windows (openings through the photoresist material) which are positioned where vias (openings through the polymer) are desired in the polymer coating. The photoresist material is thereafter exposed to actinic radiation (such as UV light) to convert the photoresist material by photochemical reaction from an insoluble material to one that is soluble in basic aqueous developer solvents. Thus, photoresist material can be selectively removed to form windows that uncover the polymer coating.

The exposed photoresist material is typically developed (or dissolved and removed), for example, by an aqueous solution consisting essentially of tetramethylammonium hydroxide (TMAH), which is commercially available under the trademark Shipley® 312. The developer solution forms water soluble salts with the exposed photoresist material and effectively allows the exposed photoresist material to be washed away. The unexposed photoresist material is not soluble in the aqueous base; therefore, the polymer material that is underneath the unexposed photoresist material is protected from the aqueous base by the layer of unexposed photoresist material.

The polymer can now be selectively etched through the windows in the photoresist material. For a coating application, this requires etching vias (or openings) through the polymer coatings to permit access for electrical connections between the conductor layers and the outside environment. In the case of a multilayer interconnect structure, access is required for connections between conductor layers or between the conductor layers and the outside environment. These openings are typically 15 to 500 µm but can be as small as 1 µm.

The polymer coating which had been located under the exposed photoresist material is now uncovered and can be etched with the wet-etch composition. The wet-etch composition is generally maintained at a temperature of from 0°C to 60°C.

There are generally at least two wet-etch application procedures for etching a coated substrate or layered module; dip-etching and spray-etching. In dip-etching, the coated substrate or layered module is dipped into a container of the wet-etch composition, and the polymer is allowed to dissolve. The polymer effectively dissolves as an infinite dilution. In spray-etching, a mist of etchant is applied to the surface of a rotating substrate or module. In this manner, fresh etchant is continually delivered to the surface, and dissolved polymer is continually being spun off. A particular etchant can behave differently in the dip-etch and spray-etch method. Also, mechanical agitation will affect the outcome of the dip-etch application procedure.

Depending on the state of cure of the polymer the cure can be completed, typically by thermal means. Thermal imidization is typically carried out at a temperature range from 100°C to 500°C, more typically from 250°C to 400°C.

The process of the present invention can also be used to produce multilayer interconnect structures. Multilayer interconnects can perform many different functions in the microelectronic field. For example, the interconnects can conduct electric power or signals within an integrated circuit or between multiple integrated circuit chips. Vias (or openings) are required through the polyimide layers to permit access for electrical connections between the conductor layers or between the conductor layers and the outside environment.

Processing multilayer interconnect structures, such as multilayer chip devices, requires a multistep procedure. As described above, polyamic acids used in step (c) are typically made by dissolving a dianhydride and a diamine in a solvent, which can be a conventional solvent or the solvent of Formula I. If a conventional solvent is used, then that solvent is substantially removed, and the polyamic acid is redissolved in the solvent of Formula I. The resulting solution of polyamic acid is used to form a coating. The polyamic acid is cured, generally by heating (typically from 100°C to 500°C, more typically from 250°C to 400°C) to form a polyimide layer.

Alternatively, the polyamic acid can be imidized to form the polyimide. When the polyamic acid is chemically imidized as described above, the polymer is isolated (precipitated) to remove the byproducts of the imidization and redissolved in the solvent of Formula I. When the polyamic acid is thermally imidized in the solvent of Formula I, the polyimide solution is used in step (c). The polyimide is typically subjected to a final cure to assure completion of the imidization and substantially remove any solvent residue.

In a multilayer device, the polyimide can be formed on various substrates which can be any material that is not decomposed in the high temperatures that are required for multilayer processing. For example, suitable substrates include silicon, metals (such as aluminum and copper), ceramic, glass, and polymeric materials.

A conductor layer is applied. The surface of the underlying polyimide can be plasma etched or reactive ion etched in a plasma before the application of the conducting material to enhance the adhesion between the polymer and the conducting material.

The layer of conducting material can be placed onto the coated substrate by standard techniques, such as electroplating, sputtering and evaporation. For example, aluminum can be deposited by E-beam evaporation and patterned using microlithography and a mask. Additional coats of polyimide can be deposited to form a multilayer structure. Typically, the conducing material is applied with a sputtering machine (such as the sputtering machine sold by CVC Products).

The conducting material is typically etched to form a pattern. Etching is generally accomplished by coating the conducting material with a photoresist material which is in a solvent and that solvent is removed, typically by heating (also called soft baking). The photoresist material is then shielded with a mask containing a pattern of openings and the photoresist material is exposed to actinic radiation, such as UV light. Thus, the photoresist material is photochemically altered such that the areas that were exposed to actinic radiation are soluble and windows are created by taking advantage of this selective solubility to develop and remove specific areas of photoresist material. The conducting material is etched through the windows in the photoresist material, generally by contacting the conducting material with a etchant that is specific for that material. For example, aluminum can be plasma etched, reactive ion etched, or etched with an aqueous solution of phosphoric acid, acetic acid, and nitric acid. Aluminum etchants are commercially available, for example, from KTI, Sunnyvale, California. This process is repeated to form a multilayer structure having the desired number of layers. Typically, the multilayer structure will have 4 to 6 layers of conducting material, but the structure can have many more layers.

When vias are required in the thick polyimide layer, the process is similar to the etching process described above. The thick polyimide layer is further coated with a photoresist material (for example Shipley 1813) which itself is in a solvent, and that solvent is removed, typically by heating (also called soft baking). The photoresist material is then shielded with a mask containing a pattern of openings, and the photoresist material is exposed to actinic radiation. Thus, the photoresist material is photochemically altered such that the areas that were exposed to actinic radiation are soluble, and windows are created by taking advantage of this selective solubility to develop and remove specific areas of photoresist material. Photoresist developers are generally basic aqueous solutions, for example tetramethylammonium hydroxide or sodium hydroxide (commercially available as Shipley 351 and 312, respectively). The thick polyimide layer can then be etched either along with the development and removal of the photoresist material or through the windows created in the photoresist material. After the thick polyimide layer is etched, the unexposed photoresist is removed, and the remaining polyimide can be cured, generally by heating, typically from 100°C to 500°C, more typically from 250°C to 400°C. Thereafter, layers of conducting material and additional polyimide can be applied as described above.

Other customary additives which do not have an adverse influence on the thick layer process can be incorporated in the thick polyimide layer during preparation of the coating composition. Examples of these additives are delustering agents, flow control agents, fine-particled fillers, flameproofing agents, fluorescent brighteners, antioxidants, light stabilizers, stabilizers, dyes, pigments, adhesion promoters, and antihalo dyes.

### EXAMPLES

All percents used are weight percents.

Solution viscosity was determined using a Brookfield Viscometer as described in ASTM D789-86 and is reported in centipoise units (cP).

Inherent Viscosity (IV) was determined at approximately 0.5 g/dl in NMP at 25°C as described in ASTM D2857.

6FDA is commercially available from Hoechst, Rhode Island. APBP is commercially available from Kennedy & Klim, Inc., Little Silver, New Jersey.

### Comparative Example A

### 6FDA/APBP in NMP

A solution of polyamic acid was prepared at room temperature in which was added 240.81 grams of 4,4'-bis(p-aminophenoxy)biphenyl (APBP), and 3,480 grams of N-methylpyrrolidinone (NMP). To the mixture was then added 279.19 grams of solid 2,2-bis(3,4-dicarboxyphenyl)-hexafluoropropane dianhydride (6FDA) with good mixing. The resulting polyamic acid was adjusted by the addition of 3.92 grams of 6FDA and 392 grams of NMP to achieve a desired solution viscosity of approximately 2,310 mPa.s (cP).

The solution was used to produce a multilayered structure consisting of two levels of polyimide (about 2 µm for each polymer layer) and one layer of aluminum.

An adhesion promoter (3-aminopropyltriethoxysilane, APES, commercially available from Aldrich) was statically dispensed to silicon wafers, and the wafers were spun (5 sec at about 500 rpm, then 30 sec at about 4000 rpm) to form an essentially monomolecular layer of adhesion promoter. Polyamic acid solution (about 12 weight percent solids content) was dispensed onto the adhesion promoter covered silicon wafers (statically dispensed) and the wafers were spun (30 sec at about 500 rpm, then 60 sec at about 3,000 rpm) to form an essentially uniform polymer layer. The polyamic acid was then heated in a nitrogen atmosphere (60 min at 200°C, then 60 min at 400°C) to imidize the polymer.

An aluminum layer (about 1 µm) was deposited on the polyimide layer with a CVC sputtering machine. The aluminum layer was coated with a positive photoresist material (Shipley 1813), and the wafers were spun (4 sec at about 500 rpm, then 25 sec at about 4,000 rpm) to form an essentially uniform photoresist layer. The photoresist was heated (soft baked) to drive off the solvent (25 min at 95°C in air). Thereafter, the photoresist material was exposed to broad band UV light (4 sec, 15 mW/cm², measured at 365 nm). The exposed photoresist material was developed and removed with a sodium hydroxide/water developer (commercially available as Shipley 351).

The aluminum was etched to form a patterned aluminum layer using an aluminum etch solution sold by KTI (2 min at approximately 40°C). The photoresist material that still remained on the aluminum was then exposed to UV light, developed, and removed (Shipley 351).

A second layer of polyamic acid was applied over the patterned aluminum layer using the same technique described for the first layer of polyamic acid. After curing, no polymer cracking was observed.

This example demonstrates that a layer of polyimide of less than 5 µm in thickness, prepared using a conventional solvent, can be multilayered without cracking.

### Comparative Example B

### 6FDA/APBP in NMP

A solution of polyamic acid was prepared at room temperature in which 45.30 grams of 4,4'-bis(p-aminophenoxy)biphenyl (APBP) and 54.71 grams of 2,2-bis(3,4-dicarboxyphenyl)hexafluoropropane dianhydride (6FDA) and 400 grams of N-methylpyrrolidinone (NMP) were added together with good mixing. The solution was later diluted with an additional 67 grams of NMP to achieve a desired solution viscosity of approximately 21,000 mPa.s (cP).

A multilayered structure having two levels of polyimide (about 10 µm for each polymer layer) and one layer of aluminum (about 2.0 - 2.5 µm) was prepared as described in Comparative Example A.

Application of the second polymer layer produced cracking in the first layer.

This Example demonstrates that a thick layer polyimide prepared using a conventional solvent shows cracking in multilayer applications.

### Example 1

### 6FDA/APBP in 2 - (2-Ethoxyethoxy)ethanol

A solution of polyamic acid was prepared at 25°C in which was added 367.59 grams of 4,4'-bis(p-aminophenoxy)biphenyl (APBP), and 3,200 grams of 2-(2-ethoxyethoxy)ethanol. To the APBP slurry was then added 432.41 grams of solid 2,2-bis(3,4-dicarboxyphenyl)-hexafluoropropane dianhydride (6FDA) with good mixing. The solution viscosity was then measured to be 38,300 mPa.s (cP).

A multilayered structure having two levels of polyimide (about 10 µm for each polymer layer) and one layer of aluminum (about 2.0 - 2.5 µm) was prepared as described in Comparative Example A.

After curing, no cracking in the underlying polymer layer was observed.

In order to examine the stability of the polyamic acid solution, samples of EXAMPLE 1 were refrigerated at from zero to 5°C for approximately a five-week period. The Brookfield viscosity was measured weekly. The viscosity was found to remain relatively stable over this period of time, from approximately 32,000 mPa.s (cP) to approximately 30,400 mPa.s (cP). However, when samples of Example 1 were stored at ambient temperature, the Brookfield viscosity was found to decrease.

### Example 2

### 6FDA/APBP in Diglyme

A solution of polyamic acid was prepared at 15°C in which were added 57.57 grams of 4,4'-bis(p-aminophenoxy biphenyl (APBP), and 610 grams of diglyme. To the APBP solution was then added 67.39 grams of solid 2,2-bis(3,4-dicarboxyphenyl)hexafluoropropane dianhydride (6FDA) with good mixing. The solution viscosity was then measured to be 17,900 mPa.s (cP).

A multilayered structure having two levels of polyimide (each about 10 µm thick) and one layer of aluminum (about 2.0 - 2.5 µm) was prepared as described in Comparative Example A.

After curing, no cracking was observed in the underlying polymer layer.

The stability of the polyamic acid solution of Example 2 was determined at ambient (room) temperature over a 24-day period. The Brookfield viscosity was measured as reported in Table I below. The viscosity was found to remain relatively stable over this period of time, from approximately 34,500 mPa.s (cP) to approximately 35,500 mPa.s (cP)

**TABLE I**

| AMBIENT TEMPERATURE 6FDA/APBP in Diglyme | |
|---|---|
| DAY NUMBER | cP* |
| 1 | 34,400 |
| 5 | 34,400 |
| 8 | 34,600 |
| 12 | 35,400 |
| 16 | 35,600 |
| 24 | 35,600 |

| | |
|---|---|
| * centipoise (1 cP = 1 mPa.s) | |

### Example 3

### 6FDA/APBP in Diglyme

A solution of polyamic acid was prepared at 15°C in which were added 371.60 grams of 4,4'-bis(p-aminophenoxy biphenyl (APBP), and 3,690 grams of diglyme. To the APBP solution was then added 438.40 grams of solid 2,2-bis(3,4-dicarboxyphenyl)hexafluoropropane dianhydride (6FDA) and 2.25 grams of water with good mixing. The sample was refrigerated at from zero to 5°C and the Brookfield viscosity was measured as reported in Tables II and III below. In Table II, the sample was refrigerated in the reactor vessel. In Table III, the sample from Table II was brought to room temperature, filtered, and rerefrigerated. The viscosity was found to remain relatively stable over this period of time.

**TABLE II**

| Refrigerated 6FDA/APBP in Diglyme | |
|---|---|
| DAY NUMBER | cP* |
| 1 | 17,600 |
| 4 | 20,000 |
| 7 | 20,500 |
| 8 | 20,500 |

| | |
|---|---|
| * centipoise (1 cP = 1 mPa.s) | |

**TABLE III**

| Refrigerated 6FDA/APBP in Diglyme | |
|---|---|
| DAY NUMBER | cP* |
| 1 | 23,000 |
| 8 | 24,000 |
| 11 | 25,600 |
| 17 | 25,200 |
| 19 | 25,200 |

| | |
|---|---|
| * centipoise ( 1 cP = 1 mPa.s) | |

### Example 4

### 6FDA/APBP in Diglyme/NMP

A polyamic acid was prepared according to the procedure described in Example 2. In addition, 4.6 grams of NMP was added to achieve a weight ratio of 95 weight percent diglyme/5 weight percent NMP. The solution viscosity was measured to be 19,500 mPa.s (cP).

The solution was used to prepare a multilayered structure having two levels of polyimide (each about 10 µm thick) and one layer of aluminum (about 2.0 - 2.5 µm) as described in Comparative Example A.

After curing, no cracking in the underlying polymer layer was observed.

### COMPARATIVE EXAMPLE C

Comparative Example C was prepared as described in Example 4 above using 82.14 grams of diglyme and 35.21 grams of NMP to achieve a ratio of 70 weight percent diglyme/30 weight percent NMP. To this solution was added 500 ppm of water. The solution viscosity was measured to be approximately 30,000 mPa.s (cP).

The solution was used to prepare a multilayered structure having two levels of polyimide (each about 10 µm thick) and one layer of aluminum (about 2.0 - 2.5 µm) as described in Comparative Example A.

Application of the second polymer layer produced cracking in the first layer after curing.

From Example 4 and Comparative Example C, it can be seen that a small amount of NMP can be present in the solvent composition without adversely effecting the ability to prepare thick layers of polyimide according to the method of the present invention. However, when the NMP concentration is increased (for example, to 30 weight percent NMP), the polymer layer exhibits cracking.

### Example 5

### 6FDA/APBP in Diglyme/2-(2-Ethoxyethoxy)ethanol

A solution of polyamic acid was prepared at ambient temperature in which were added 20.40 grams of 4,4'-bis(p-aminophenoxy biphenyl (APBP), 112.94 grams of diglyme and 112.52 grams of 2-(2-ethoxyethoxy)ethanol. To the APBP solution was then added 24.60 grams of 2,2-bis(3,4-dicarboxyphenyl)hexafluoropropane dianhydride (6FDA) with good mixing. The solution viscosity was then measured to be 16,000 mPa.s (cP).

The solution was used to prepare a multilayered structure having two levels of polyimide (each about 10 µm thick) and one layer of aluminum (about 2.0 - 2.5 µm) as described in Comparative Example A.

After curing, no cracking in the underlying polymer layer was observed.

Samples of Example 5 were refrigerated at from zero to 5°C for a period of 75 days. The Brookfield viscosity was measured as shown in Table IV below. The viscosity was found to remain relatively stable over this period of time, from 16,000 mPa.s (cP) to 16,400 mPa.s (cP).

**TABLE IV**

| 6FDA/APBP in Diglyme/2- (2-Ethoxyethoxy)ethanol | |
|---|---|
| DAY NUMBER | cP* |
| 1 | 16,000 |
| 6 | 16,000 |
| 29 | 16,400 |
| 75 | 16,400 |

| | |
|---|---|
| * centipoise (1 cP = 1 mPa.s) | |

### Example 6

### 6FDA/APBP Polyimide Redissolved in Diglyme

A solution of polyamic acid was prepared in which were added 45.96 grams of 4,4'-bis(p-aminophenoxy biphenyl (APBP) and 404.2 grams of NMP. To the APBP solution was then added 54.09 grams of 2,2-bis(3,4-dicarboxyphenyl)hexafluoropropane dianhydride (6FDA) with good mixing to form a polyamic acid (IV 0.83 dl/g). The polyamic acid was imidized by adding 26.90 grams of acetic anhydride and 26.66 grams of triethylamine to the polyamic acid solution. The polyimide was precipitated with water in a Waring blender, filtered and washed with water, and dried for four days in a vacuum oven at 120°C with a nitrogen purge. The IV of the polyamic acid precipitate was 0.77 dl/g.

Polyimide (3.35 grams) was dissolved into 13.5 grams of diglyme to form a 20 weight percent solids solution. The IV was 0.77 dl/g and the solution viscosity was 9,760 mPa.s (cP).

A multilayered structure having two levels of polyimide (each about 10 µm thick) and one layer of aluminum (about 2.0 - 2.5 µm) was prepared as described in Comparative Example A.

After curing, no cracking was observed in the underlying polymer layer.

## Claims

1. A method of forming a multilayer polyimide coated substrate which comprises providing successive layers of fluorinated polyimide on the substrate,each layer being at least 5µm thick **characterised by** the steps of
(a) forming a first polyimide layer comprising a fluorinated polyimide which is susceptible to degradation by conventional aprotic polar solvents by applying a first layer of polyamic acid to the substrate,
(b) imidizing the first layer of polyamic acid to form said first polyimide layer, and
(c) providing a second polyimide layer comprising a fluorinated polyimide over the first polyimide layer by
(i) applying a solution in a solvent, of a polyamic acid or a polyimide, and
(ii) if necessary, imidizing polyamic acid applied in step (i),
and wherein said solvent consists of one or more compounds of the formula (I) 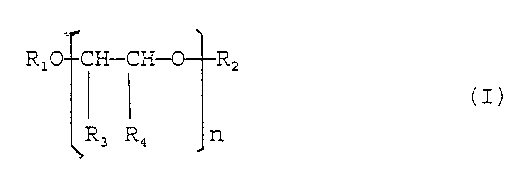 and optionally a small amount of polar aprotic solvent, said amount not resulting in cracking of the underlying layer, wherein
R₁ and R₂ are independently hydrogen, a C₁ to C₆ alkyl moiety, or 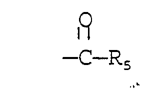 wherein R₅ is a C₁ to C₆ alkyl moiety;
R₃ and R₄ are independently hydrogen or a C₁ to C₆ alkyl moiety; and
n is from 1 to 4.

2. The method of Claim 1 wherein the solvent comprises a lower alkyl ether alcohol.

3. The method of Claim 2 wherein the solvent comprises 2-(2-ethoxyethoxy)ethanol.

4. The method of Claim 1 wherein the solvent comprises an ether.

5. The method of Claim 4 wherein the solvent comprises 2-methoxyethyl ether.

6. The method of any preceding claim wherein the fluorinated polyimide comprises the reaction product of 2,2-bis(3,4-dicarboxyphenyl)hexafluoropropane dianhydride and at least one diamine.

7. The method of any preceding claim wherein step (c) is repeated to provide successive layers of fluorinated polyimide on the substrate.

8. A method according to any preceding claim wherein n is at least 2.

9. The method of any preceding claim further including applying a patterned conductor layer between steps (b) and (c) .

10. A method of preventing cracking in an underlying polyimide layer on a substrate wherein said underlying layer comprises a fluorinated polyimide which is susceptible to degradation by conventional aprotic polar solvents when additional layers of fluorinated polyamic acid are applied to the underlying polyimide layer which comprises:
(a) forming a first polyimide layer comprising a fluorinated polyimide which is susceptible to degradation by conventional aprotic polar solvents by applying a first layer of polyamic acid to the substrate;
(b) imidizing the first layer of polyamic acid to provide said first polyimide layer; and
(c) applying a layer of fluorinated polyamic acid over the first layer of polyimide wherein the polyamic acid is in a solvent of the formula 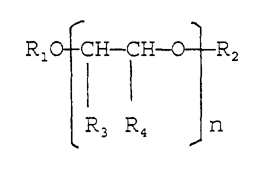 wherein
R₁ and R₂ are independently hydrogen, a C₁ to C₆ alkyl moiety, or 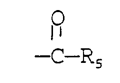 wherein R₅ is a C₁ to C₆ alkyl moiety;
R₃ and R₄ are independently hydrogen or a C₁ to C₆ alkyl moiety; and
n is from 1 to 4, and
(d) imidizing the polyamic acid.

11. The method of Claim 10 further including applying a patterned conductor layer between steps (b) and (c).

12. A method of forming multiple layers of fluorine-containing polyimide on a substrate which comprises:
(a) applying a first layer of fluorine-containing polyamic acid to the substrate;
(b) imidizing the first layer of polyamic acid to provide a first polyimide layer;
(c) applying a layer of fluorinated polyamic acid over the first layer of polyimide wherein the polyamic acid is in a solvent of the formula 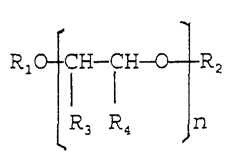 wherein
R₁ and R₂ are independently hydrogen, a C₁ to C₆ alkyl moiety, or 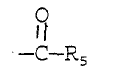 wherein R₅ is a C₁ to C₆ alkyl moiety;
R₃ and R₄ are independently hydrogen or a C₁ to C₆ alkyl moiety; and
n is from 1 to 4 and
(d) imidizing the polyamic acid.

13. The method of Claim 12 further including applying a patterned conductor layer between steps (b) and (c).

14. A method according to any of Claims 10 to 13 wherein the solvent and polymer is as defined in any of Claims 2 to 6.

15. A method according to any preceding claim wherein the coated substrate comprises a plastic optical waveguide, a plastic optical fiber, or a coated substrate for use in electronic applications.

## Patentansprüche

1. Verfahren zur Bildung eines mehrschichtigen, polyimidbeschichteten Substrats, das umfasst das Bereitstellen von aufeinander folgenden Schichten aus fluoriertem Polyimid auf dem Substrat, wobei jede Schicht mindestens 5 µm dick ist, **gekennzeichnet durch** die Schritte des
(a) Ausbildens einer ersten Polyimidschicht, umfassend ein fluoriertes Polyimid, das über herkömmliche aprotische polare Lösungsmittel zersetzt werden kann, **durch** Auftragen einer ersten Schicht aus Polyamidsäure auf das Substrat,
(b) Imidieren der ersten Schicht aus Polyamidsäure zum Bilden der ersten Polyimidschicht und
(c) Bereitstellen einer zweiten Polyimidschicht, umfassend ein fluoriertes Polyimid, über der ersten Polyimidschicht **durch**
(i) Auftragen einer Lösung einer Polyamidsäure oder eines Polyimids in einem Lösungsmittel, und
(ii) falls erforderlich, Imidieren der im Schritt (i) aufgetragenen Polyamidsäure,
und worin das Lösungsmittel aus einer oder mehreren Verbindungen der Formel (I) 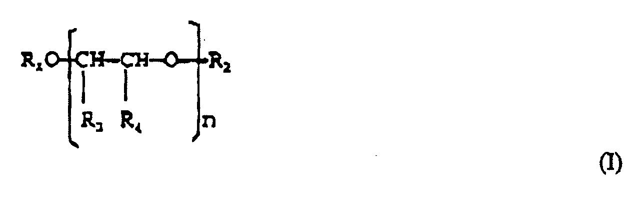 und wahlweise einer kleinen Menge an polarem aprotischen Lösungsmittel besteht, wobei diese Menge nicht zum Aufreißen der unterliegenden Schicht führt, worin
R₁ und R₂ unabhängig voneinander Wasserstoff, eine C₁-C₆-Alkyleinheit oder 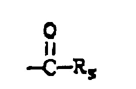 darstellen, worin R₅ eine C₁-C₆-Alkyleinheit ist;
R₃ und R₄ unabhängig Wasserstoff oder eine C₁-C₆-Alkyleinheit darstellen; und
n von 1 bis 4 ist.

2. Verfahren gemäß Anspruch 1, worin das Lösungsmittel einen niederen Alkyletheralkohol umfasst.

3. Verfahren gemäß Anspruch 2, worin das Lösungsmittel 2-(2-Ethoxyethoxy)ethanol umfasst.

4. Verfahren gemäß Anspruch 1, worin das Lösungsmittel einen Ether umfasst.

5. Verfahren gemäß Anspruch 4, worin das Lösungsmittel 2-Methoxyethylether umfasst.

6. Verfahren gemäß einem der vorstehenden Ansprüche, worin das fluorierte Polyimid das Reaktionsprodukt von 2,2-bis-(3,4-Dicarboxyphenyl)-hexafluorpropandianhydrid und mindestens einem Diamin umfasst.

7. Verfahren gemäß einem der vorstehenden Ansprüche, worin Schritt (c) wiederholt wird, um aufeinander folgende Schichten an fluoriertem Polyimid auf dem Substrat bereitzustellen.

8. Verfahren gemäß einem der vorstehenden Ansprüche, worin n mindestens 2 beträgt.

9. Verfahren gemäß einem der vorstehenden Ansprüche, zusätzlicb umfassend das Auftragen einer gemusterten Leiterschicht zwischen den Schritten (b) und (c).

10. Verfahren zur Verhinderung bzw. Vorbeugung des Aufreißens in einer unterliegenden Polyimidschicht auf einem Substrat, worin die unterliegende Schicht ein fluoriertes Polyimid umfasst, das über herkömmliche aprotische polare Lösungsmittel zersetzt werden kann, wenn zusätzliche Schichten aus fluorierter Polyamidsäure auf die unterliegende Polyimidschicht aufgetragen werden, das umfasst:
(a) Ausbilden einer ersten Polyimidschicht, umfassend ein fluoriertes Polyimid, das durch herkömmliche aprotische polare Lösungsmittel zersetzt werden kann, durch Auftragen einer ersten Schicht aus Polyamidsäure auf das Substrat;
(b) Imidieren der ersten Schicht aus Polyamidsäure, um die erste Polyimidschicht bereitzustellen; und
(c) Auftragen einer Schicht aus fluorierter Polyamidsäure über der ersten Schicht aus Polyimid, worin die Polyamidsäure sich in einem Lösungsmittel der Formel 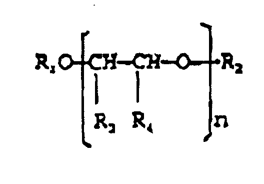 befindet, worin
R₁ und R₂ unabhängig Wasserstoff, eine C₁-C₆-Alkyleinheit oder 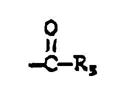 bedeuten, worin R₅ eine C₁-C₆-Alkyleinheit ist;
R₃ und R₄ unabhängig Wasserstoff oder eine C₁-C₆-Alkyleinheit darstellen; und
n von 1 bis 4 ist, und
(d) Imidieren der Polyamidsäure.

11. Verfahren gemäß Anspruch 10, zusätzlich umfassend das Auftragen einer gemusterten Leiterschicht zwischen den Schritten (b) und (c).

12. Verfahren zur Ausbildung mehrerer Schichten aus Fluor enthaltendem Polyimid auf einem Substrat, das umfasst:
(a) Auftragen einer ersten Schicht aus Fluor enthaltender Polyamidsäure auf das Substrat;
(b) Imidieren der ersten Schicht aus Polyamidsäure, um eine erste Polyimidschicht bereitzustellen;
(c) Aufbringen einer Schicht aus fluorierter Polyamidsäure über der ersten Polyimidschicht, worin die Polyamidsäure sich in einem Lösungsmittel der Formel 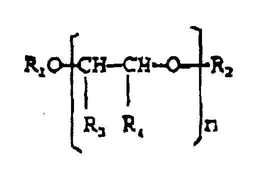 befindet, worin
R₁ und R₂ unabhängig Wasserstoff, eine C₁-C₆-Alkyleinheit oder 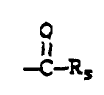 bedeuten, worin R₅ eine C₁-C₆-Alkyleinheit ist;
R₃ und R₄ unabhängig Wasserstoff oder eine C₁-C₆-Alkyleinheit darstellen; und
n von 1 bis 4 ist, und
(d) Imitdieren der Polyamidsäure.

13. Verfahren gemäß Anspruch 12, zusätzlich umfassend das Auftragen einer gemusterten Leiterschicht zwischen den Schritten (b) und (c).

14. Verfahren nach einem der Ansprüche 10 bis 13, worin das Lösungsmittel und das Polymer wie in einem der Ansprüche 2 bis 6 definiert sind.

15. Verfahren gemäß einem der vorstehenden Ansprüche, worin das beschichtete Substrat einen optischen Wellenleiter aus Kunststoff, eine optische Faser aus Kunststoff oder ein beschichtetes Substrat für die Verwendung in Elektronikanwendungen umfasst.

## Revendications

1. Procédé pour former un substrat revêtu de polyimide multicouche qui comprend la production de couches successives de polyimide fluoré sur le substrat, chaque couche étant épaisse d'au moins 5 µm, **caractérisé par** les étapes de
(a) formation d'une première couche de polyimide comprenant un polyimide fluoré qui est susceptible de dégradation par les solvants polaires aprotiques conventionnels par application d'une première couche d'acide polyamique au substrat,
(b) imidation de la première couche d'acide polyamique pour former ladite première couche de polyimide, et
(c) production d'une seconde couche de polyimide comprenant un polyimide fluoré sur la première couche de polyimide par
(i) application d'une solution dans un solvant d'un acide polyamique ou d'un polyimide, et
(ii) si nécessaire, imidation de l'acide polyamique appliqué dans l'étape (i),
et où ledit solvant consiste en un ou plusieurs composés de formule (I) 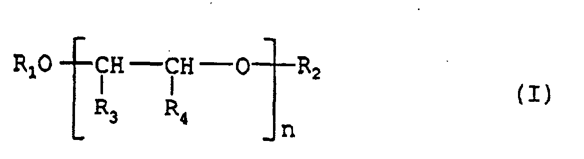 et éventuellement en une petite quantité de solvant aprotique polaire, ladite quantité ne conduisant pas à une fissuration de la couche sous-jacente, où
R₁ et R₂ sont indépendamment l'hydrogène, une entité alkyle en C₁ à C₆ ou 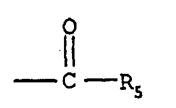 où R₅ est une entité alkyle en C₁ à C₆ ;
R₃ et R₄ sont indépendamment l'hydrogène ou une entité alkyle en C₁ à C₆ ; et
n est de 1 à 4.

2. Procédé selon la revendication 1 où le solvant comprend un alkyle inférieur-étheralcool.

3. Procédé selon la revendication 2 où le solvant comprend le 2-(2-éthoxyéthoxy)éthanol.

4. Procédé selon la revendication 1 où le solvant comprend un éther.

5. Procédé selon la revendication 4 où le solvant comprend le 2-méthoxyéthyléther.

6. Procédé selon l'une quelconque des revendications précédentes où le polyimide fluoré comprend le produit de la réaction du 2,2-bis(3,4-dicarboxyphényl)hexafluoropropane-dianhydride et d'au moins une diamine.

7. Procédé selon l'une quelconque des revendications précédentes où l'étape (c) est répétée pour produire des couches successives de polyimide fluoré sur le substrat.

8. Procédé selon l'une quelconque des revendications précédentes où n est au moins 2.

9. Procédé selon l'une quelconque des revendications précédentes incluant en outre l'application d'une couche conductrice munie d'un motif entre les étapes (b) et (c).

10. Procédé pour empêcher la fissuration dans une couche de polyimide sous-jacente sur un substrat où ladite couche sous-jacente comprend un polyimide fluoré qui est susceptible de dégradation par les solvants polaires aprotiques conventionnels quand des couches supplémentaires d'acide polyamique fluoré sont appliquées à la couche de polyimide sous-jacente qui comprend :
(a) la formation d'une première couche de polyimide comprenant un polyimide fluoré qui est susceptible de dégradation par les solvants polaires aprotiques conventionnels par application d'une première couche d'acide polyamique au substrat ;
(b) l'imidation de la première couche d'acide polyamique pour produire ladite première couche de polyimide ; et
(c) l'application d'une couche d'acide polyamique fluoré sur la première couche de polyimide où l'acide polyamique est dans un solvant de formule 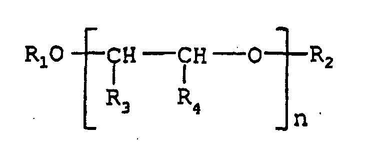 où
R₁ et R₂ sont indépendamment l'hydrogène, une entité alkyle en C₁ à C₆ ou 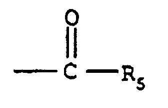 où R₅ est une entité alkyle en C₁ à C₆ ;
R₃ et R₄ sont indépendamment l'hydrogène ou une entité alkyle en C₁ à C₆ ; et
n est de 1 à 4, et
(d) l'imidation de l'acide polyamique.

11. Procédé selon la revendication 10 incluant en outre l'application d'une couche conductrice munie d'un motif entre les étapes (b) et (c).

12. Procédé de formation de multiples couches de polyimide fluoré sur un substrat qui comprend :
(a) l'application d'une première couche d'acide polyamique fluoré au substrat ;
(b) l'imidation de la première couche d'acide polyamique pour produire une première couche de polyimide ;
(c) l'application d'une couche d'acide polyamique fluoré sur la première couche de polyimide où l'acide polyamique est dans un solvant de formule 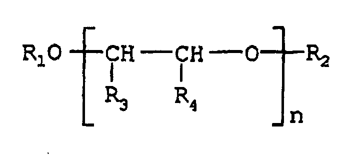 où
R₁ et R₂ sont indépendamment l'hydrogène, une entité alkyle en C₁ à C₆ ou 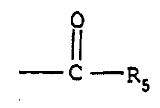 où R₅ est une entité alkyle en C₁ à C₆ ;
R₃ et R₄ sont indépendamment l'hydrogène ou une entité alkyle en C₁ à C₆ ; et
n est de 1 à 4, et
(d) l'imidation de l'acide polyamique.

13. Procédé selon la revendication 12 incluant en outre l'application d'une couche conductrice munie d'un motif entre les étapes (b) et (c).

14. Procédé selon l'une quelconque des revendications 10 à 13 où le solvant et le polymère sont définis comme dans l'une quelconque des revendications 2 à 6.

15. Procédé selon l'une quelconque des revendications précédentes où le substrat revêtu comprend un guide d'ondes optiques plastique, une fibre optique plastique ou un substrat revêtu destiné à être utilisé dans des applications électroniques.
